(19) Europäisches Patentamt / European Patent Office / Office européen des brevets

(11) **EP 2 641 113 B1**

(12) **FASCICULE DE BREVET EUROPEEN**

(45) Date de publication et mention
de la délivrance du brevet:
**21.01.2015  Bulletin 2015/04**

(21) Numéro de dépôt: **11784484.5**

(22) Date de dépôt: **15.11.2011**

(51) Int Cl.:
*G02B 1/10* (2015.01)      *H05K 9/00* (2006.01)
*H01L 31/0352* (2006.01)

(86) Numéro de dépôt international:
**PCT/EP2011/070139**

(87) Numéro de publication internationale:
**WO 2012/065987 (24.05.2012 Gazette 2012/21)**

(54) **HUBLOT OPTRONIQUE TRANSPARENT IR ET REFLECHISSANT RF**

OPTRONISCHES FENSTER MIT IR-TRANSPARENZ UND RF-REFLEXION

OPTRONIC WINDOW TRANSPARENT TO IR AND REFLECTING RF

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **16.11.2010  FR 1004448**

(43) Date de publication de la demande:
**25.09.2013  Bulletin 2013/39**

(73) Titulaire: **THALES
92200 Neuilly-sur-Seine (FR)**

(72) Inventeurs:
  • **CZARNY, Romain**
    **F-91767 PALAISEAU Cedex (FR)**
  • **REVERCHON, Jean-Luc**
    **F-91767 PALAISEAU Cedex (FR)**
  • **PATE, Michel**
    **F-91767 PALAISEAU Cedex (FR)**
  • **LOISEAUX, Brigitte**
    **F-91767 PALAISEAU Cedex (FR)**
  • **BERGINC, Gérard**
    **F-78995 ELANCOURT Cedex (FR)**

(74) Mandataire: **Henriot, Marie-Pierre et al
Marks & Clerk France
Conseils en Propriété Industrielle
Immeuble Visium
22, Avenue Aristide Briand
94117 Arcueil Cedex (FR)**

(56) Documents cités:
  **FR-A1- 2 793 106       FR-A1- 2 928 463
  JP-A- 1 170 098          US-A- 5 173 443
  US-A- 6 099 970          US-A1- 2007 071 970
  US-A1- 2008 174 872**

  • **Ott, H. W.: "Electromagnetic Compatibility
    Engineering", 2009, John Wiley and Sons,
    hoboken, NJ, USA, XP002644548, ISBN:
    978-0-470-18930-6 page 288 - page 290**
  • **LITVINOV V I ET AL: "Conductive Coating with
    Infrared Pass Band", PROC. SPIE, vol. 4094, 2000,
    pages 38-45, XP002644552, ISSN: 0277-786X**
  • **LIPKIN N. ET AL.: "Dual band transparent
    conductive coating", PROC. SPIE, vol. 4375,
    2001, pages 315-321, XP002644553, ISSN:
    0277-786X**

**Description**

Le domaine de l'invention est celui de la Compatibilité Electro-Magnétique (CEM) des équipements optroniques montés à bord d'aéronefs (télémètre laser, LIDAR, camera VIS/IR, équipement optronique d'aide à l'atterrissage, etc.).

En effet, la présence de fenêtres optiques sur ce type d'équipement expose l'intérieur de ces dispositifs aux ondes électromagnétiques environnantes et réciproquement. On désigne par fenêtre optique l'ensemble d'un hublot transparent encastré dans une structure mécanique ; un hublot a typiquement un diamètre de 15 à 40 cm. Cette exposition aux ondes électromagnétiques peut avoir comme conséquences :

- la perturbation du fonctionnement du dispositif optronique,
- la perturbation du fonctionnement des différents équipements électroniques environnants (radar, communication radio, etc.).

L'utilisation d'une fenêtre optique transparente dans la gamme de longueur d'onde optique utilisée (300 nm à 20 $\mu$m) et réfléchissante aux ondes RF (1 MHz à 100 GHz) permet d'assurer une continuité électrique au niveau de la carcasse de l'équipement et de constituer ainsi une cage de Faraday. La fenêtre optronique est alors non transparente dans la bande RF.

Aujourd'hui, trois techniques sont principalement employées afin de réaliser la combinaison des 2 effets recherchés : transparence optique et réflectivité/absorption micro-onde.

Une première technique consiste à associer au hublot optique une grille métallique de même dimension.

D'un point de vue hyperfréquence, cette grille se comporte comme un filtre passe-hautes fréquences dont les performances sont liées à la taille des fils de la grille, à son pas et à la nature du métal utilisé (généralement de l'or ou du cuivre). En effet, pour les longueurs d'ondes grandes devant le pas de la grille et pour des épaisseurs de pénétration du champ électromagnétique (dites épaisseurs de peau) plus petites que l'épaisseur de fil de la grille, celle-ci est vue comme une couche métallique uniforme et donc réfléchissante.

D'un point de vue optique, les fils de la grille se comportent comme des éléments diffractants. Pour une longueur d'onde donnée, c'est l'efficacité de diffraction déterminée par la périodicité de la grille ainsi que par la taille des fils par rapport à la longueur d'onde considérée, qui va déterminer les pertes optiques. Par exemple, une grille de cuivre de 30 $\mu$m de diamètre de fil avec une maille régulière (un pas) de 224 $\mu$m présente une transparence optique dans le visible de 78%.

Les performances de tels dispositifs sont principalement limitées par des limitations technologiques. En effet, lorsque la grille doit être auto-supportée mécaniquement, son diamètre de fil et son pas ne peuvent être réduits au-delà des limites de résistance des matériaux ; la diffraction optique devient alors trop importante.

Signalons aussi l'existence de grilles bi-périodiques mettant en oeuvre des matériaux semi-conducteurs et permettant de coupler l'onde RF incidente dans une couche absorbante.

Une autre technique employée consiste à déposer sur le hublot optique, une couche conductrice transparente. A cette fin, des métaux déposés en couche fine ou des oxydes dopés sont couramment employés (or en couche mince, ITO, ZnO). Pour les fréquences micro-ondes, la couche semi-transparente se comporte comme un métal permettant de réfléchir uniformément les ondes dont la fréquence est inférieure à la fréquence plasma. Cette technique est typiquement employée sur des verrières d'avion ou d'hélicoptère.

Si cette technique peut donner satisfaction dans le visible (notamment pour toutes les applications liées à la visualisation), ce n'est pas le cas pour les longueurs d'onde supérieures à 1,5 $\mu$m où, lorsque la couche est suffisamment conductrice avec une résistance surfacique typiquement inférieure à 10 $\Omega$/carré, les ondes IR sont fortement réfléchies et/ou absorbées. Les conductivités typiques sont de l'ordre de la dizaine d'ohm/carré pour une transmission de 40% à 1,5 $\mu$m.

Enfin une troisième technique, différente des deux autres, met en oeuvre une surface sélective en fréquence du type écran de Salisbury, avec des matériaux optiquement compatibles.

Ce type de surface est constitué d'un dioptre hyperfréquence partiellement réfléchissant, d'un substrat d'une épaisseur effective de $\lambda$/4, suivi d'une surface RF hautement réfléchissante. Ainsi, les réflexions RF sur le premier dioptre sont couplées en opposition de phase avec la réflexion sur le dioptre hautement réfléchissant entraînant ainsi une diminution de la réflectivité RF du hublot.

Ces surfaces réfléchissantes peuvent être réalisées à l'aide de grilles ou de couches semi-transparentes comme présentées précédemment.

Ce type de filtre n'est efficace que pour une bande de fréquence étroite. Il existe des techniques pour élargir la bande de fonctionnement de ce type de dispositif (écran de Jaumann par exemple) ; cependant, elles conduisent à la réalisation de structures relativement épaisses.

Parmi les documents de l'état de la technique, on peut citer US 6 099 970 qui décrit notamment un hublot optronique et la publication « Electromagnetic Compatibility Engineering » de Ott, H.W qui présente des moyens pour lutter contre les interférences électromagnétiques.

En conséquence, il demeure à ce jour un besoin pour un hublot donnant simultanément satisfaction à l'ensemble des exigences précitées, en termes de bonne transmission IR, faible transmission RF et bonne résistance mécanique.

L'invention est basée sur l'utilisation d'un substrat transparent entre 0,4 et 5 $\mu$m associé à un empilement d'hétéro-structures, chaque hétéro-structure comportant des couches semi-conductrices de grande énergie de bande interdite (typiquement supérieure à 1 eV) et des porteurs électriques mobiles avec une mobilité typiquement supérieure à 100 cm$^2$/V/s.

L'utilisation de couches semi-conductrices de grande énergie de bande interdite confère une bonne transparence IR supérieure à 90%; son épaisseur de l'ordre de 10 $\mu$m ainsi que la grande mobilité des porteurs supérieure à 100 cm$^2$/V/s garantissent sa conductivité et donc sa réflectivité RF.

Plus précisément l'invention a pour objet un hublot optronique qui comporte un substrat à deux faces, avec sur l'une des faces du substrat ou sur les deux, un empilement de plusieurs hétéro-structures, chaque hétéro-structure étant composée d'au moins deux couches semi-conductrices SC1, SC2, la couche SC1 étant dopée, la couche SC2 comportant elle-même une couche de gaz d'électrons bi-dimensionnel formée à l'interface avec la couche SC1, les couches et le substrat étant transparents entre 0,4 et 5 $\mu$m. Il est principalement caractérisé en ce qu'il comporte une électrode en contact avec toutes les couches de gaz d'électrons.

Il comporte en outre une grille métallique bi-périodique en contact avec l'électrode, qui est enterrée dans l'empilement. Elle est généralement à mailles régulières. Elle a typiquement un fil d'épaisseur inférieure à 5 $\mu$m et un pas inférieur à 500 $\mu$m.

La présence des canaux d'électrons bidimensionnels de type 2DEG ("Two-Dimensional Electron Gas") permet d'augmenter la mobilité des porteurs dans la structure et donc d'augmenter la réflectivité RF et la transparence IR.

Selon une caractéristique de l'invention, la couche semi-conductrice SC2 est non dopée.

Selon une autre caractéristique de l'invention, les hétéro-structures sont d'épaisseur différente et/ou ne sont pas composées des mêmes matériaux et/ou ne comportent pas le même nombre de couches.

Ce hublot comporte typiquement un empilement de 10 à 80 hétéro-structures.

Il peut comporter une couche tampon entre le substrat et l'empilement d'hétéro-structures, ainsi qu'une ou deux couches antireflets.

Le substrat est en général en Saphir ou SiC ou Si, la couche SC2 en GaN et la couche SC1 en AlGaN avec une concentration d'Al comprise entre 25 à 30%.

L'épitaxie du GaN sur Saphir permet de réaliser des fenêtres de très grande résistance mécanique et thermique (forte liaison covalente entre Ga et N à l'origine de la grande énergie de bande interdite : entre 3,2 et 3,4 eV). La température de croissance supérieure à 1000°C lui confère une grande stabilité thermique.

L'invention a aussi pour objet une fenêtre optronique qui comporte un hublot tel que décrit encastré dans une structure mécanique électriquement conductrice, l'électrode du hublot étant reliée à cette structure électriquement conductrice.

D'autres caractéristiques et avantages de l'invention apparaîtront à la lecture de la description détaillée qui suit, faite à titre d'exemple non limitatif et en référence aux dessins annexés dans lesquels :

les figures 1 représentent schématiquement une structure cristalline de GaN, cubique et non polaire de type Zinc Blende (fig 1 a) et hexagonale et polaire de type Würtzite (fig 1 b),
les figures 2 représentent schématiquement une structure de bande d'énergie du réseau d'hétéro-structures permettant la mise en parallèle de canaux 2DEG de grande mobilité, en fonction de la direction normale au substrat, pour une largeur typique de réseau supérieure à 100 nm (fig 2a) et inférieure (fig 2b),
la figure 3a donne l'épaisseur totale du réseau requise en fonction de la densité de porteurs moyenne dans le réseau pour obtenir une transmission RF variant entre -10 et -50 dB pour une mobilité de 1500 cm$^2$/V/s, la figure 3b donne l'absorption liée aux porteurs libres à $\lambda$=4,5 $\mu$m en fonction de la densité de porteurs dans chaque canal pour la même mobilité,
les figures 4 représentent schématiquement un hublot selon l'invention, réalisé sur substrat circulaire en perspective (fig 4a), vu de dessus (fig 4b), selon une coupe AA avec un empilement de trois hétéro-structures (fig 4c),
les figures 5 donnent les coefficients de réflexion, transmission et absorption optiques (fig 5a) et la transmission RF (fig 5b) obtenus pour un hublot à 80 hétéro-structures totalisant 8 $\mu$m d'épaisseur, comportant une grille de 400 $\mu$m de pas avec des fils d'or de 5x5 $\mu$m$^2$,
la figure 6 représente schématiquement une fenêtre optronique selon l'invention.

D'une figure à l'autre, les mêmes éléments sont repérés par les mêmes références.

Selon un premier mode de réalisation de l'invention, un substrat possédant la transparence requise entre 0,4 et 5 $\mu$m et de très bonnes propriétés physiques et mécaniques, tel que le saphir, est associé à un empilement d'hétéro-structures comportant des couches semi-conductrices de grande énergie de bande interdite et des porteurs mobiles.

Parmi les couches semi-conductrices utilisées, on peut citer par exemple une couche semi-conductrice de GaN ; le GaN ayant la particularité de pouvoir croître avec une bonne qualité cristallographique sur le saphir, ce procédé permet ainsi d'obtenir une structure de très grande tenue mécanique et thermique.

Le comportement de la couche de GaN dépend de la densité de porteurs libres ainsi que de leur mobilité. A partir de ces deux grandeurs et des propriétés intrinsèques du matériau, on peut définir une grandeur caractéristique appelée fréquence plasma $f_p$ (elle correspond à la fréquence électromagnétique pour laquelle la partie réelle de la permittivité du matériau est nulle) :

$$f_p = \frac{1}{2\pi} \sqrt{\frac{n_e q^2}{\varepsilon_0 \varepsilon_R m_{eff}} - \frac{q^2}{m_{eff}^2 \mu_e^2}}$$

avec ne la densité de porteur, $m_{eff}$ leur masse effective et $\mu_e$ la mobilité de ces porteurs, q la charge électrique de l'électron, $\varepsilon_0$ la permittivité du vide, $\varepsilon_R$ la permittivité relative du matériau considéré. Cette fréquence peut être associée à une longueur d'onde dite longueur d'onde plasma $\lambda_p$:

$$\lambda_p = \frac{c}{f_p}$$

avec c la vitesse de la lumière dans le vide.

Ainsi, le comportement de la couche semi-conductrice de GaN dépend de la longueur d'onde considérée :

- Pour les longueurs d'onde électromagnétiques inférieures à $\lambda_p$ (les ondes IR et du visible dans notre cas) cette couche va se comporter comme un diélectrique et donc être traversée avec des pertes. La transparence du matériau dans cette gamme de longueur d'onde va dépendre notamment de la densité de porteurs libres et de leur mobilité dans la structure de GaN.
- Pour les longueurs d'ondes supérieures à $\lambda_p$ (les ondes RF dans notre cas), cette couche va se comporter comme un métal et créer un court circuit d'un point de vue radiofréquence. L'onde incidente est donc réfléchie, les performances dépendent de la qualité du court circuit réalisé et donc de la résistivité de surface de la couche de GaN.

L'onde incidente est d'autant plus réfléchie que la couche est conductrice c'est-à-dire comporte une densité de porteurs libres élevée (supérieure à $10^{18}$ cm$^{-3}$), et une mobilité élevée (supérieure à 100 cm$^2$/V/s). Nous aurons alors une fenêtre optronique non transparente aux ondes RF.

On rappelle les caractéristiques optiques de la couche semi-conductrice. Celles qui sont liées aux interactions avec les porteurs libres peuvent être décrites à l'aide du modèle de Drude. A partir des paramètres intrinsèques du matériau ainsi que ceux des porteurs (densité, masse effective et mobilité) on peut calculer en fonction de la longueur d'onde, la permittivité complexe $\varepsilon = \varepsilon_1 + i\varepsilon_2$ et l'indice complexe N=n-ik du matériau. Pour une longueur d'onde $\lambda$, les pertes linéiques optiques $\alpha$, qui sont liées à l'absorption par porteurs libres sont alors reliées à la partie complexe de l'indice d'après:

$$\alpha = \frac{4\pi}{\lambda} k$$

La transmission $T_{opt}$ et l'absorption $A_{opt}$ optiques (liées à une traversée unique, sans considération des réflexions aux interfaces) de la couche semi-conductrice d'épaisseur d est donc donnée par :

$$T_{Opt} = e^{-\alpha d} \quad \text{et} \quad A_{Opt} = 1 - e^{-\alpha d}$$

On rappelle les caractéristiques hyperfréquences de la couche semi-conductrice :

- Pour des épaisseurs d fines devant l'épaisseur de peau, les caractéristiques radiofréquences de la couche semi-conductrice sont notamment déterminées par sa résistance de surface $R_S$.

$$R_S = \frac{1}{d n_e \mu_e q}$$

- Pour une couche auto-portée, la transmission RF peut alors être donnée par la formule suivante :

$$T_{RF} \approx -20 \log\left(1 + \frac{60\pi}{R_S}\right) \qquad \text{en dB.}$$

On considère à présent la problématique de la croissance du GaN sur un substrat saphir.

La croissance est le plus couramment réalisée suivant l'axe c de la structure cristalline Würtzite sur un substrat saphir d'orientation [0001]. Néanmoins, des dispositifs avec un axe c non perpendiculaire au substrat (dans le plan pour une structure non polaire ou suivant des directions (x,y,z) semi-polaires) apparaissent progressivement.

Une des problématiques de la croissance est liée au désaccord de maille entre les différents matériaux composant l'hétéro-épitaxie. La croissance de GaN sur substrat de saphir ($Al_2O_3$) se fait alors avec un axe cristallin horizontal (a) tourné de 30° par rapport au substrat.

Les différences de coefficient de dilatation contribuent également aux problèmes mécaniques lors de la croissance effectuée aux alentours de 1000°C. Les données pour différents types de matériaux sont consignées dans le tableau suivant pour des semi-conducteurs de la famille III-N en structure Wurtzite.

| Matériau | Paramètre de maille(A) | Coefficient de dilatation K-1 |
|---|---|---|
| Al2O3 | 4,7558 | 7.5 x 10-6 |
| Al2O3 (30°) / √3 | 2,74 | |
| GaN | 3,189 | 5.59 x 10-6 |
| AIN | 3,112 | 4.2 x 10-6 |
| InN | 3,548 | |
| BN | 2,2556 | |

L'une des principales techniques de croissance mise en oeuvre pour dépasser ce désaccord de maille est l'usage d'une couche tampon épitaxiée à basse température (entre 450 et 600 °C) de quelques dizaines de nanomètres d'épaisseur. Elle permet d'adapter le paramètre de maille à celui de semi-conducteur III-N (GaN ou AIN de préférence).

Cette technique permet de réaliser des épitaxies à haute température (supérieure à 1000 °C) avec un paramètre de maille et une orientation cristalline adaptés. Ceci conduit à l'obtention de couches de très bonne transparence optique. La rugosité de surface typique est inférieure à 5 nm RMS (acronyme de l'expression anglo-saxonne Root Mean Square pour écart type).

Une autre technique, bien connue de la littérature, consiste à réaliser par exemple un multicouche de binaires AIN / GaN afin de piéger les dislocations « traversantes » à l'interface entre ces couches. Ces multi-couches permettent du même coup de créer des gaz d'électrons bidimensionnels pouvant contribuer à la conductivité électrique comme on va le voir.

En effet, dans un semi-conducteur massif, la mobilité est donc liée à la densité de défauts et donc au dopage : plus le dopage est élevé et plus la mobilité est faible. Dans un tout autre domaine que celui de la compatibilité électromagnétique, qui est celui des transistors HEMTs ("High-Electron-Mobility-Transistors), une des techniques utilisée pour augmenter la mobilité des porteurs, consiste à :

- dissocier physiquement la zone dopée de la zone de transport afin de limiter la densité d'impuretés dans la zone de transport et donc d'optimiser la mobilité des porteurs,
- positionner le niveau de Fermi au-dessus de la bande de conduction dans la zone de transport afin d'y créer une zone où des porteurs libres (confinés sur 2 dimensions) sont présents en grande densité.

Ceci est réalisé à l'aide d'une hétéro-jonction qui permet de créer un canal bi-dimensionnel, appelé 2DEG ("Two-Dimensional Electron Gas"), où la mobilité et la densité des porteurs sont très élevées. Par rapport à des couches massives simples, ce type d'hétérojonction, permet donc de réaliser des assemblages dont la résistivité électrique est bien plus faible.

La conduction électrique se faisant dans le plan des couches, des ondes RF incidentes polarisées TEM sont donc susceptibles d'interagir avec le "gaz" d'électrons libres du 2DEG.

Les fonctions requises pour la microélectronique sont très différentes de celles qui nous préoccupent ici. Bien que l'emploi d'un gaz d'électrons soit également utilisé en microélectronique, la mise en parallèle (dans des plans parallèles) d'un grand nombre de canaux de conduction ne s'applique pas à la micorélectronique.

Le principe de base de l'invention consiste à empiler ce type d'hétérostructure les unes au-dessus des autres sur le substrat afin de constituer un réseau de gaz bidimensionnels permettant de réaliser une hétérostructure avec :

- une résistivité globale encore plus faible que dans un semi-conducteur massif, grâce à la mise en parallèle de l'ensemble des canaux et
- une transparence IR accrue grâce à la forte mobilité des porteurs dans les couches 2DEG.

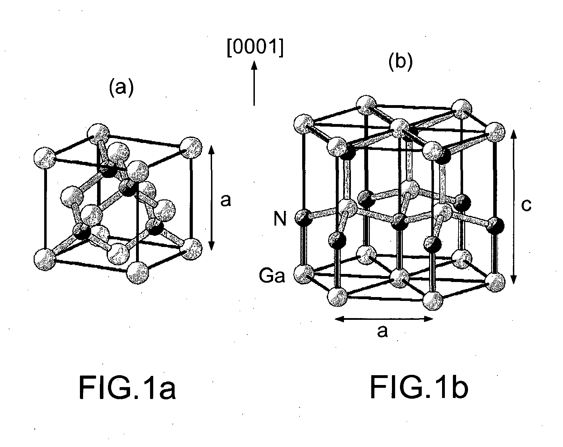

Dans le cas d'une hétérojonction AlGaN/GaN en structure cristalline hexagonale et polaire de type Würtzite, ou cubique et non polaire de type Zinc Blende (respectivement présentées figures 1 a et 1 b), les porteurs sont généralement fournis par le dopage résiduel ou intentionnel présent ; un effet piézo-électrique permet de polariser naturellement la jonction et de remplir le canal. Dans le cas d'un réseau de plusieurs hétérojonctions, cet effet piézo-électrique est insuffisant pour remplir l'ensemble des canaux à partir de porteurs issus de la surface. On propose donc de doper les barrières d'AlGaN localement (c'est-à-dire seulement sur une partie de l'épaisseur de la barrière) selon un dopage n ou éventuellement p, et préférentiellement périodiquement.

Le taux d'aluminium utilisé (typiquement entre 25 et 30 %) permet de garantir une croissance épitaxiale bidimensionnelle. Contrairement aux applications microélectroniques (transistor notamment), l'absence de cracks ainsi que l'isolation électrique entre couches n'est pas requise. Ceci facilite notoirement la réalisation de ce type de structure.

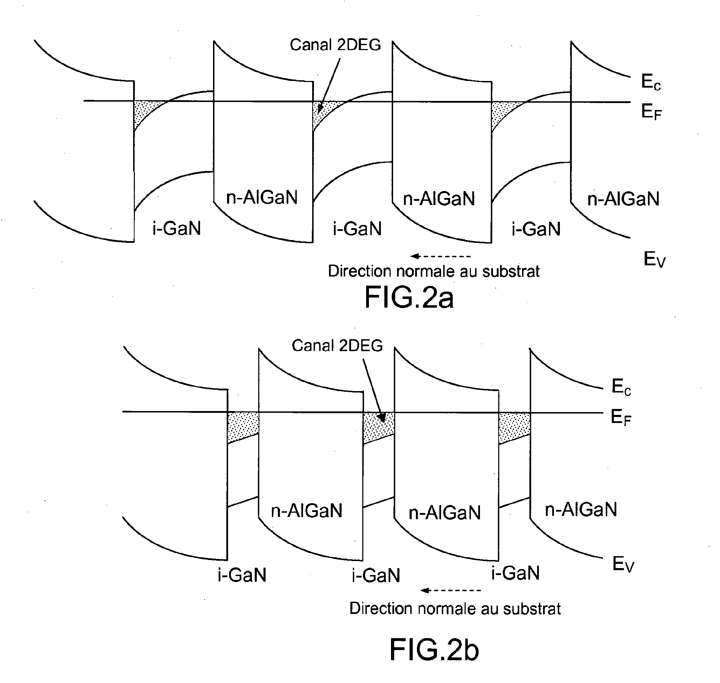

Lorsque la largeur typique de la période du réseau est supérieure à 100 nm, on peut retrouver des canaux qui ont le même profil que ceux que l'on rencontre dans les transistors de type HEMT. Ce type de réseau est présenté sur la figure 2a, où $E_f$ désigne le niveau de Fermi, $E_c$ l'énergie de bande de conduction, $E_v$ l'énergie de bande de valence.

Lorsque les canaux deviennent étroits (< 100 nm), on retrouve alors une architecture de bande d'énergie de type multi-puits quantiques où les électrons présents dans le puits peuvent être distribués sur des niveaux énergétiques discrets. Ce type de réseau est présenté sur la figure 2b.

Si ce type de structure s'apparente aux structures des détecteurs infrarouges QWIP, acronyme de l'expression anglo-saxonne Quantum Well Infrared Photodetector (photo-détecteur infrarouge à puits quantiques), le fonctionnement et l'utilisation sont complètement différents. En effet, l'onde optique IR sous incidence normale (compte tenu de l'indice optique du GaN, l'incidence maximale dans cette couche est de 25°) présente une polarisation orientée parallèlement au plan des couches. Ainsi cette onde n'interagit pas avec les niveaux énergétiques discrets dans les puits quantiques et il n'y a pas d'absorption optique (comme dans les QWIP) liée à des transitions intra ou inter-sous-bande. Cette polarisation implique cependant une interaction avec les "gaz bi-dimensionnels" d'électrons libres confinés dans le plan des couches, ce qui peut se traduire par une absorption optique liée aux porteurs libres.

De la même manière, une onde RF TEM sous incidence normale excite ces "gaz bidimensionnels" et interagit, compte tenu de l'épaisseur de la structure par rapport à la longueur d'onde RF, avec une couche unique équivalente de très bonne conductivité électrique.

L'onde optique incidente quant à elle voit ce réseau comme une couche d'indice effectif équivalent à la moyenne des indices de la structure, pondérée des épaisseurs. En effet, l'épaisseur des couches (de l'ordre de quelques dizaines de nanomètres) est bien plus faible que la plus petite des longueurs d'onde optique considérées (~ 400 nm). Qui plus est, la différence d'indice optique entre deux matériaux de la famille (Al, Ga)N est très faible (moins de 0,2) et induit peu d'interférences.

La mobilité dans les canaux dépend en grande partie de l'architecture de bande retenue et les techniques traditionnelles d'optimisation de mobilité dans ces structures 2DEG peuvent être utilisées :

- optimisation de la largeur des canaux,
- optimisation de la profondeur (énergétique) des canaux,
- optimisation du dopage des barrières,
- utilisation de zones non dopées et éventuellement de composition différente à proximité des canaux,
- utilisation de couches tampons sur le substrat,
- etc...

Pour préserver les performances de transparence IR, cette optimisation doit se faire en limitant la densité de porteurs $n_{2DEG}$ dans les canaux. En effet, une chute de la transmission IR est obtenue lorsque les densités de porteurs dans les canaux conduisent à l'obtention d'une longueur d'onde plasma plus petite que la longueur d'onde IR $\lambda_{IR}$

considérés :

$$n_{2DEG} < \varepsilon_0 \varepsilon_R \left( \frac{4\pi^2 m_{eff} c^2}{\lambda_{IR}^2 q^2} \right)$$

Ainsi, pour une longueur d'onde IR maximale de 4,5 $\mu$m on limite la densité de porteur dans les canaux à ~ $6.10^{19}$ cm$^{-3}$.

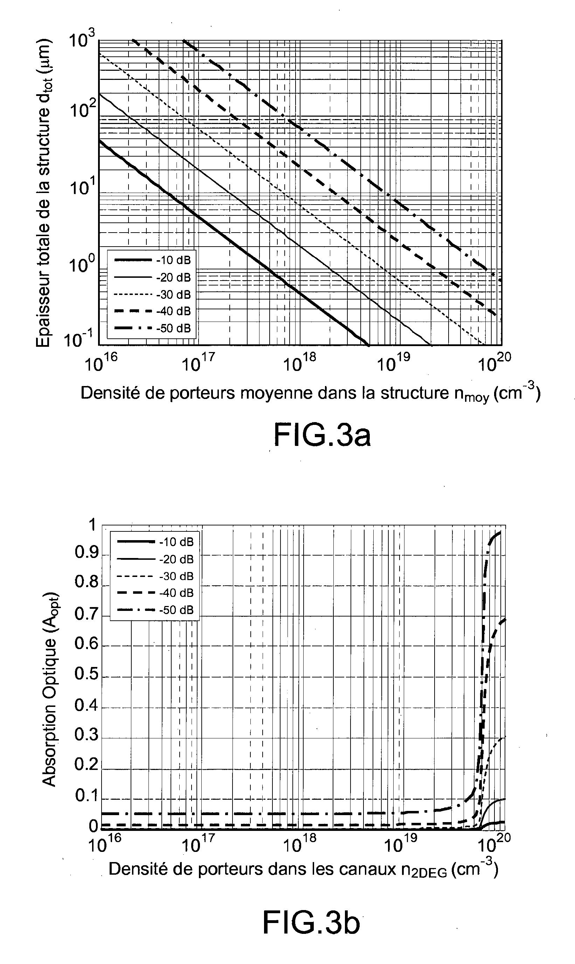

La figure 3a représente l'épaisseur totale $d_{tot}$ du réseau qu'il est nécessaire de réaliser pour une mobilité de 1500 cm$^2$/V/s dans les canaux ; des mobilités de 1900 cm$^2$/V/s sont proposées dans des structures commercialisées. Cette épaisseur est représentée en fonction du dopage moyen n$_{moy}$ dans l'ensemble du réseau et pour différentes valeurs de réflectivité RF recherchées.

En fonction de l'architecture de réseau retenue, la densité de porteurs n$_{2DEG}$ dans les canaux peut varier pour une même densité de porteurs moyenne. En fonction de cette densité de porteurs et en considérant une épaisseur totale de structure conforme à la figure 3a, il est possible de calculer l'absorption IR liée aux porteurs libres dans les canaux. Ces résultats sont représentés sur la figure 3b pour une longueur d'onde IR de 4,5 $\mu$m.

En outre une électrode est formée pour être en contact avec toutes les couches de gaz d'électrons. Elle est destinée à être électriquement reliée à la structure mécanique électriquement conductrice dans laquelle est encastré le hublot.

Une grille métallique est intégrée au hublot tel que décrit précédemment. Cette intégration peut se faire en enterrant la grille dans une couche semi-conductrice épi-structurée ou en déposant la grille à la surface.

Cette grille se comporte comme un filtre passe haut dans le domaine RF. Le diamètre des fils déposés est faible afin de limiter l'occultation optique. La taille de la maille de la grille dépend de la fréquence de coupure requise.

Compte tenu de l'indice de réfraction de la couche de GaN (~ 2,3) la proportion de rayons optiques qui est diffractée dans le substrat avec des angles supérieurs à 25° sont filtrés puisqu'ils restent piégés par réflexion totale interne.

Le motif de la grille peut être déposé de manière pseudo-aléatoire ou apériodique afin d'éviter la création d'ordres de diffraction.

Le diamètre de fil de la grille doit être supérieur à la profondeur de pénétration du champ électromagnétique dans le métal (épaisseur de peau $\delta$) qui dépend de la fréquence basse à laquelle le dispositif doit être utilisé:

$$\delta = \frac{1}{\sqrt{f}} \frac{1}{\sqrt{\pi \kappa \mu_0 \mu_R}}$$

avec $\mu_0$ la perméabilité du vide et $\mu_R$ la perméabilité relative du matériau.

Par exemple, à 1 GHz, pour un fil d'or (conductivité $\kappa$ = 45,2 $10^6$ S/m $\mu_R$ = 1), l'épaisseur de peau $\delta$ est de 2,3 $\mu$m.

Ce mode de réalisation combine les performances d'isolation RF des grilles pour les basses fréquences (filtre passe haut) et les performances de la couche semi-conductrice épi-structurée à haute fréquence.

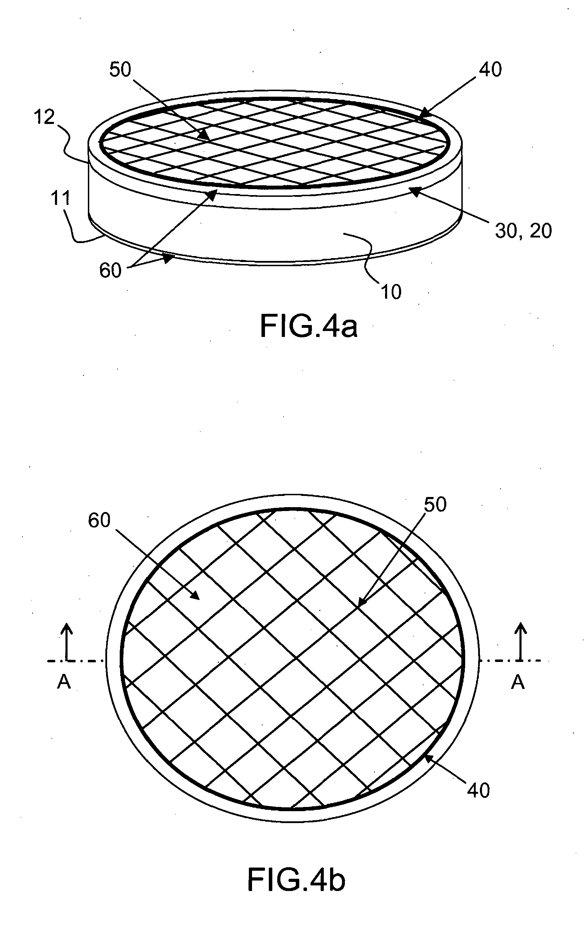

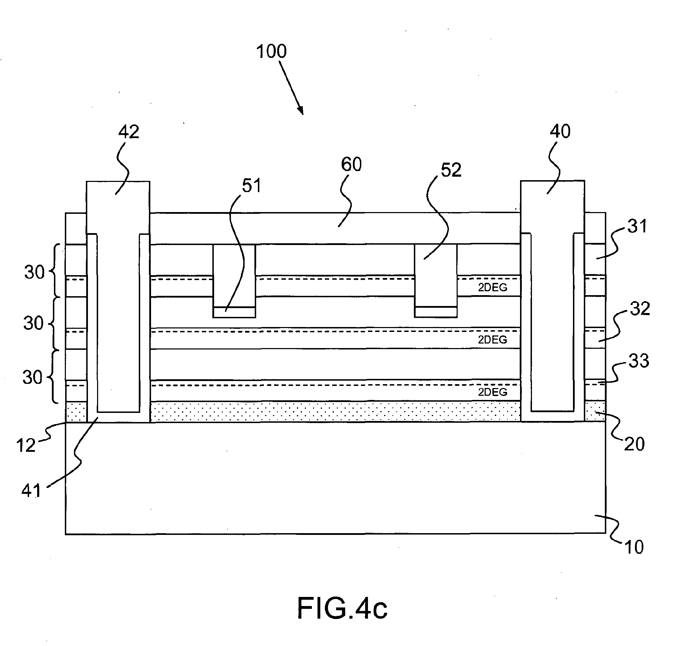

On va à présent décrire en relation avec les figures 4, un exemple de réalisation d'un hublot 100 selon ce mode de réalisation, avec une grille métallique enterrée dans le réseau d'hétéro-structures. Dans cet exemple toutes les hétéro-structures (trois) sont identiques bien que cela ne soit pas nécessaire comme on le verra plus loin ; la couche semi-conductrice SC1 est du n-AlGaN, la couche semi-conductrice non dopée SC2 du GaN, mais là encore d'autres exemples de matériaux seront donnés.

Il est tout d'abord réalisé à partir d'un substrat plan 10 (pas nécessairement de symétrie de révolution), dont l'une des faces 11 est polie avec une qualité optique et l'autre 12 polie avec une qualité compatible d'une croissance par épitaxie (face dite épi-ready). Ce substrat peut être du saphir éventuellement orienté c, ou du silicium pour des réalisations à 1,06 $\mu$m en bande II, à 1,55 $\mu$m en bande III, ou du SiC pour aller du visible jusqu'à la bande III. Il peut aussi s'agir d'un substrat hôte tel qu'obtenu par la technologie « Smart Cut » qui consiste principalement à reporter sur un substrat hôte éventuellement de grande dimension, des hétérostructures fabriquées à part et dont on a retiré le substrat initial.

Une couche tampon 20, peut être préalablement déposée du côté épi-ready : éventuellement une couche de GaN ou AlN de quelques nanomètres d'épaisseur (de 20 à 50 nm) et épitaxiée à basse température (de l'ordre de 450 à 600 °C) suivie d'une couche de GaN ou de GaAlN de quelques microns (~2 $\mu$m) épitaxiée à haute température (supérieure à 1000 °C).

Directement sur le substrat 10 ou sur cette couche tampon 20, un empilement d'hétérostructures 30 GaN/AlGaN est épitaxié de manière à former plusieurs canaux 2DEG 33 les uns au-dessus des autres. De préférence, les couches SC2 32 de GaN ne sont pas dopées. Les couches barrière SC1 31 d'AlGaN sont dopées n périodiquement (éventuellement avec du Silicium). Sur la figure, on a représenté un empilement de couches GaN/n-AlGaN ; on pourrait l'inverser et réaliser un empilement de couches n-AlGaN /GaN.

Eventuellement, les épaisseurs de chacune des barrières peuvent être légèrement différentes les unes des autres afin d'éviter la création d'une structure de type miroir de Bragg.

Le nombre de couches semi-conductrices et les matériaux peuvent varier d'une hétéro-structure à l'autre.

La densité de dopage dans les barrières 31 d'AlGaN, leur épaisseur, l'épaisseur des couches 32 de GaN ainsi que la taille totale de la structure épitaxiée dépendent des performances requises en termes de résistance électrique globale de la couche et de la transparence optique requise dans la bande d'intérêt.

On va décrire à présent l'étape de réalisation de l'électrode 40 et de la grille 50.

Sur la face épi-structurée, une ouverture sur toute la périphérie de l'échantillon et sur toute la profondeur du réseau GaN/AlGaN est effectuée, éventuellement jusqu'au substrat 10. On s'assure que la gravure permet une bonne prise de contact sur ses flancs.

Une deuxième gravure reprenant le motif de la grille à déposer est effectuée. La profondeur et la largeur de la gravure dépendent de la taille des fils 50 de la grille à déposer, et donc des performances RF recherchées. Comme montré figures 4a et 4b, on s'assure que le motif de la grille utilisée recoupe l'ouverture en périphérie afin d'assurer après métallisation la continuité électrique entre la grille et l'électrode.

Des contacts ohmiques 41 et 42 sont déposés au fond des deux ouvertures puis recuits. Eventuellement ces contacts peuvent être à base de Ti/Al/Ni/Au, de Ti/Al/Mo/Au, de Ti/Al/Ir/Au, etc. Un recuit haute température (de l'ordre de 800°C) permet d'obtenir un contact électrique de bonne qualité. Sur les figures 4a et 4b, la grille est bi-périodique à maille régulière (même période selon les deux axes), mais les deux périodes peuvent être différentes.

Un autre dépôt métallique 42 peut être réalisé afin d'épaissir et éventuellement élargir le contact 41. Ce contact peut être réalisé à base de Ti/Au suivi d'une recharge électrolytique d'Au. L'électrode 40 est ainsi composée d'un contact ohmique 41 et de cet autre dépôt métallique 42.

Un autre dépôt métallique 52 peut être réalisé afin d'épaissir et éventuellement élargir le contact 51. Ce contact peut être réalisé à base de Ti/Au suivi d'une recharge électrolytique d'Au. Avantageusement, l'épaisseur du métal ainsi déposé ne dépasse pas la hauteur de l'hétéro-structure afin de protéger efficacement la grille. Les fils de grille 50 sont ainsi composés d'un contact ohmique 51 et de cet autre dépôt métallique 52.

L'électrode 40 obtenue permet d'assurer un contact électrique avec les canaux 2DEG 33 de GaN et ainsi d'assurer une continuité électromagnétique entre le hublot 100 et son support mécanique faisant office de référence électrique. Cette métallisation épaisse qui permet de reprendre le contact électrique sur le hublot peut aussi recouvrir le support mécanique dans lequel il est encastré. Ainsi, il devient possible d'assurer la continuité électrique du hublot en le contactant par le côté.

Des couches antireflets 60 peuvent être déposées sur chacune des deux faces du hublot (éventuellement uniquement sur la face côté grille ou uniquement sur la face 11 du substrat) afin de réduire les réflexions optiques aux interfaces, aux longueurs d'onde d'intérêt et éviter la formation de cavités Fabry-Pérot (liées à l'interface GaN/saphir notamment). Chacune de ces 2 couches 60 peut être optimisée indépendamment, les indices du saphir (~1,8) et de l'AlGaN (~2,3) étant différents. Eventuellement, ces couches 60 peuvent être soit à base de diélectriques ou de semi-conducteurs à grand gap (tels que le diamant, TiO2, $MgF_2$, ZnS, ou autres ...) soit à base de matériaux sub-lambda nano-structurés ; éventuellement il peut s'agir directement de l'hétérostructure.

Une ouverture est pratiquée dans les couches antireflets (côté épi-structuré) afin de permettre un accès au contact périphérique épaissi 40.

Selon une variante de réalisation, l'empilement d'hétérostructures n'est pas épitaxié mais reporté sur la face épi-ready du substrat.

Encore d'autres variantes peuvent être réalisées :

Le GaN peut être remplacé par un semi-conducteur III-N tel que :

- AlN (énergie de bande interdite plus élevée que GaN : Eg=6.2 eV soit λg=200 nm) ce qui permet d'étendre la transparence de la couche semi-conductrice dans le proche UV. Par extension, toutes les compositions de $Al_xGa_{1-x}N$ qui permettent de positionner l'énergie de bande interdite entre 6,2 eV et 3,4 eV.
- InN (énergie de bande interdite plus faible que GaN : Eg=0.65 eV soit λg=1,9 μm). Ce qui permet de couper le visible et le proche infrarouge jusqu'à 2 μm, d'améliorer la densité de porteurs et leur mobilité. Par extension, toutes les compositions de $In_xGa_{1-x}N$ qui permettent de positionner l'énergie de bande interdite entre 3,2 eV et 0,65eV.
- les matériaux de la famille $Al_xIn_yGa_{1-x-y}N$
- les matériaux de la famille $Al_xIn_yGa_{1-x-y}As_zN_{1-z}$.
- du diamant, notamment nano-cristallin ou nano-structuré.

L'hétéro-structure GaN/AlGaN peut être remplacée par un semi-conducteur de la famille II-VI (ZnO, MgZnO).

Un semi-conducteur III-N (cf la liste des matériaux cités précédemment) peut être utilisé pour réaliser les canaux 2DEG et les barrières SC1 différents de GaN et d'AlGaN.

Un semi-conducteur de la famille II-VI (ZnO, MgZnO) peut être utilisé à la place du réseau GaN/AlGaN.

Un écran de Salisbury peut être réalisé à l'aide d'un empilement d'hétéro-structures tel que décrit précédemment, de part et d'autre de la fenêtre de saphir. Pour un effet interférométrique à 10 GHz, l'épaisseur de saphir ($\varepsilon_R$=11,58) peut être de 2,2 mm (soit $\lambda$/4) ou de 6,61 mm (soit 3$\lambda$/4). La couche de GaN en face avant doit présenter une réflectivité de 50 % (soit une résistance surfacique de l'ordre de 450 $\Omega$/carré). La face arrière du dispositif doit présenter une réflectivité la plus élevée possible.

Les avantages du hublot selon l'invention par rapport à l'état de l'art précité sont les suivants :

- Compatibilité technologique entre la couche conductrice donnant les propriétés RF et un substrat d'intérêt pour les applications optiques Visible et IR grâce à l'épitaxie directe sur substrat de saphir.
- Transparence dans la bande visible et IR (de 0,4 $\mu$m jusqu'à 5 $\mu$m).
- Très faible absorption IR et forte réflectivité RF grâce à la mobilité élevée des porteurs dans les canaux 2DEG.
- Faible diffraction optique.
- Indice optique faible pour un semi-conducteur (~2,3 à 500 nm) qui limite les réflexions optiques à l'interface saphir/GaN à ~ 1,5%.
- Très bonne tenue au flux optique pour les longueurs d'onde inférieures à 0,4 $\mu$m (très faible absorption dans la couche de GaN car l'énergie des photons est inférieure à l'énergie de bande interdite, et très bonne conductivité thermique du GaN). En particulier pour les configurations qui ne comportent pas de partie métallique exposée (ou exposable) à des flux optiques, telle qu'une grille.
- Performances inégalées en termes d'isolation radiofréquence pour la configuration avec grille. En effet, sur ce type de configuration, on associe les performances des grilles à basse fréquence au pouvoir isolant à hautes fréquences des couches dopées.
- Très grande résistance à l'érosion de la face réfléchissante pour les configurations sans grille ou avec grille enterrée et donc protégée car le GaN est un matériau très dur, comparable au saphir. Ceci peut permettre l'utilisation de la fenêtre avec la face épitaxiée en face avant (vers l'extérieur du système optronique à isoler).
- Facilité d'intégration de la grille dans le cas de la configuration avec grille, car les hétérostructures de GaN sont faciles à graver avec des procédés de micro-électronique adaptés (RIE acronyme de l'expression anglo-saxonne « Reactive Ion Etching », ICP acronyme de l'expression anglo-saxonne « Inductively Coupled Plasma », etc.).

Un hublot a été réalisé de la manière suivante.

- Le substrat de saphir utilisé est un substrat circulaire orienté suivant l'axe c [0001] de 150 mm de diamètre et de 8 mm d'épaisseur. Une des faces est polie avec une qualité optique. L'autre face est polie avec une qualité épi-ready.
- Sur la face épi-ready, une couche tampon constituée de 20 nm de GaN basse température suivi de 2 $\mu$m de Al.$_{27}$Ga.$_{73}$N haute température non dopée est déposée.
- Sur cette couche tampon, un réseau de 80 hétérostructures de GaN/Al.$_{27}$Ga.$_{73}$N (100/900 Å) est épitaxié. Les couches de GaN ne sont pas dopées et les couches d'AlGaN sont dopées à 2,2.10$^{18}$ cm$^3$. Des couches d'AlN non dopées de 1 nm d'épaisseur sont utilisées à l'interface AlGaN / GaN afin de limiter les effets de la rugosité d'interface sur la mobilité des électrons du gaz 2D ; ces couches d'AlN sont un exemple de troisièmes couches SC3 des hétérostructures. La mobilité des porteurs dans les canaux (et dans le plan des couches) est de 1500 cm$^2$/V/s.
- Le réseau d'hétérostructures est ouvert sur 5 $\mu$m de profondeur et 5 $\mu$m de large avec un motif du type grille au pas de 400 $\mu$m. Sur toute la périphérie du substrat, une ouverture de 1000 $\mu$m de large sur toute la profondeur épitaxiée est pratiquée. Dans ces deux ouvertures, un contact ohmique de Ti/Al/Mo/Au (150/600/350/500 Å) y est déposé puis recuit. Un deuxième dépôt de Ti/Au (150/500 Å) est déposé suivi d'une recharge électrolytique d'Au pour atteindre une épaisseur de 5 $\mu$m d'Au et une largeur de contact de 5 mm au niveau du contact périphérique.
- Au-dessus de cette structure, une couche antireflet de 275 nm de MgF$_2$ est déposée de manière à optimiser la transmission à 1,5 $\mu$m. Une ouverture au niveau de cette couche de MgF$_2$ est pratiquée afin de libérer l'accès au contact périphérique.
- Sur l'autre face du substrat, un traitement diélectrique multicouche est déposé.

On a obtenu les résultats suivants :

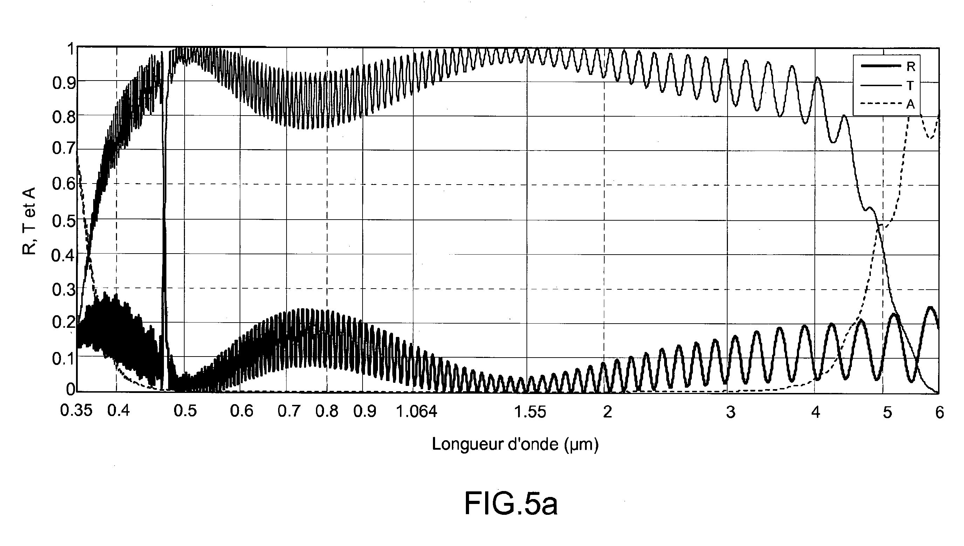

A 4,5 $\mu$m, l'absorption liée aux porteurs libres dans le super réseau est de 1,4%. Les propriétés de transparence, d'absorption et de réflexion globale de la structure sont représentées sur la figure 5a.

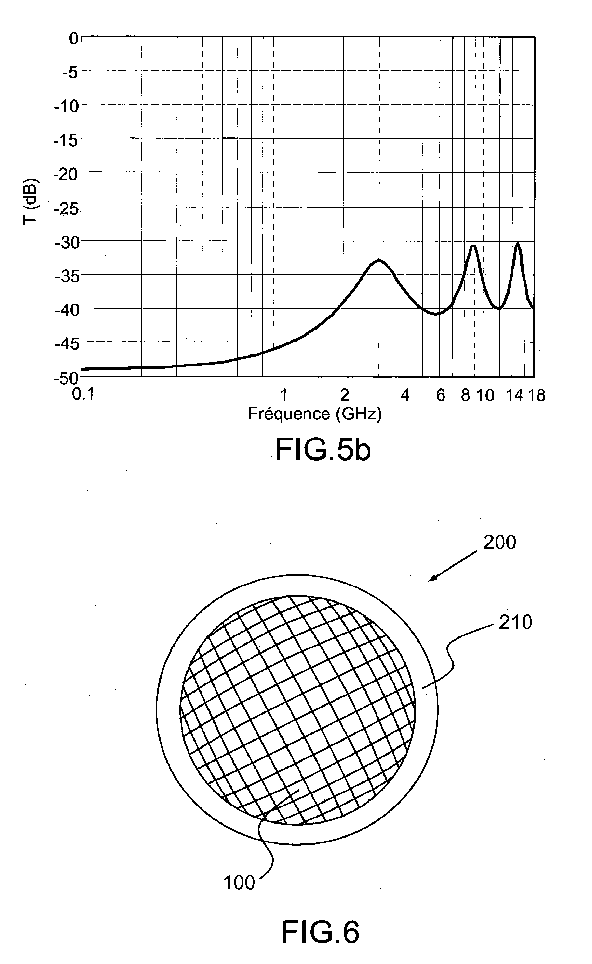

La résistivité surfacique de la structure obtenue est de 2,6 Ohm/carré, ce qui permet d'obtenir une transmission RF pour une couche équivalente auto-portée de -37 dB. Sur le substrat de saphir, les résultats de transmission RF sont représentés sur la figure 5b.

## Revendications

1. Hublot optronique (100) qui comporte un substrat (10) à deux faces (11, 12), avec sur l'une des faces du substrat ou sur les deux faces, un empilement de plusieurs hétéro-structures (30), chaque hétéro-structure étant composée d'au moins deux couches semi-conductrices (31, 32) SC1, SC2, la couche SC1 (31) étant dopée, la couche SC2 (32) comportant elle-même une couche (33) de gaz d'électrons bi-dimensionnel formée à l'interface avec la couche SC1, le substrat et les couches étant transparents dans la bande 0,4 $\mu$m-5 $\mu$m, **caractérisé en ce qu'**il comporte une électrode (40) en contact avec toutes les couches (33) de gaz d'électrons, et une grille métallique bi-périodique enterrée dans l'empilement, en contact avec l'électrode (40)..

2. Hublot optronique (100) selon la revendication précédente, **caractérisé en ce que** la grille est à mailles régulières.

3. Hublot optronique (100) selon l'une des revendications précédentes, **caractérisé en ce que** la grille a un fil (50) d'épaisseur inférieure à 5 $\mu$m et un pas inférieur à 500 $\mu$m.

4. Hublot optronique (100) selon l'une des revendications précédentes, **caractérisé en ce que** la couche semi-conductrice SC2 (32) est non dopée.

5. Hublot optronique (100) selon l'une des revendications précédentes, **caractérisé en ce que** les hétéro-structures (30) sont d'épaisseur différente et/ou ne sont pas composées des mêmes matériaux et/ou ne comportent pas le même nombre de couches.

6. Hublot optronique (100) selon l'une des revendications précédentes, **caractérisé en ce qu'**il comporte un empilement de 10 à 80 hétéro-structures (30).

7. Hublot optronique (100) selon l'une des revendications précédentes, **caractérisé en ce qu'**il comporte une couche tampon (20) entre le substrat (10) et l'empilement d'hétéro-structures (30).

8. Hublot optronique (100) selon l'une des revendications précédentes, **caractérisé en ce qu'**il comporte une ou deux couches antireflets (60).

9. Hublot optronique (100) selon l'une des revendications précédentes, **caractérisé en ce que** le substrat (10) est en Saphir ou SiC ou Si et **en ce que** la couche SC2 (32) est en GaN et la couche SC1 (31) en AlGaN avec une concentration d'Al comprise entre 25 à 30%.

10. Fenêtre optronique (200) qui comporte un hublot (100) selon l'une des revendications précédentes encastré dans une structure (210) mécanique électriquement conductrice, l'électrode (40) du hublot étant reliée à cette structure électriquement conductrice.

## Patentansprüche

1. Optronisches Fenster (100), das ein Substrat (10) mit zwei Flächen (11, 12) aufweist, mit einer Stapelung mehrerer Hetorostrukturen (30) auf einer der Flächen des Substrats oder auf den zwei Flächen, wobei jede Heterostruktur aus mindestens zwei halbleitenden Schichten (31, 32) SC1, SC2 zusammengesetzt ist, wobei die Schicht SC1 (31) dotiert ist, wobei die Schicht SC2 (32) selbst eine zweidimensionale Elektronengasschicht (33) aufweist, die an der Schnittstelle mit der Schicht SC1 ausgebildet ist, wobei das Substrat und die Schichten im Band 0,4 $\mu$m-5 $\mu$m transparent sind, **dadurch gekennzeichnet, dass** es eine Elektrode (40) im Kontakt mit allen Elektronengasschichten (33) und ein zweiperiodisches Metallgitter, das in die Stapelung eingebracht ist, im Kontakt mit der Elektrode (40) aufweist.

2. Optronisches Fenster (100) nach vorangehendem Anspruch, **dadurch gekennzeichnet, dass** das Gitter regelmäßige Maschen hat.

3. Optronisches Fenster (100) nach einem der vorangehenden Ansprüche, **dadurch gekennzeichnet, dass** das Gitter einen Draht (50) mit einer Dicke unter 5 $\mu$m und einer Steigung unter 500 $\mu$m hat.

4. Optronisches Fenster (100) nach einem der vorangehenden Ansprüche, **dadurch gekennzeichnet, dass** die halbleitende Schicht SC2 (32) nicht dotiert ist.

5. Optronisches Fenster (100) nach einem der vorangehenden Ansprüche, **dadurch gekennzeichnet, dass** die Heterostrukturen (30) unterschiedlicher Dicke sind und/oder nicht aus denselben Materialien zusammengesetzt sind und/oder nicht dieselbe Anzahl an Schichten aufweisen.

6. Optronisches Fenster (100) nach einem der vorangehenden Ansprüche, **dadurch gekennzeichnet, dass** es eine Stapelung von 10 bis 80 Heterostrukturen (30) aufweist.

7. Optronisches Fenster (100) nach einem der vorangehenden Ansprüche, **dadurch gekennzeichnet, dass** es zwischen dem Substrat (10) und der Stapelung von Heterostrukturen (30) eine Pufferschicht (20) aufweist.

8. Optronisches Fenster (100) nach einem der vorangehenden Ansprüche, **dadurch gekennzeichnet, dass** es eine oder zwei Antireflex-Schichten (60) aufweist.

9. Optronisches Fenster (100) nach einem der vorangehenden Ansprüche, **dadurch gekennzeichnet, dass** das Substrat (10) aus Saphir oder SiC oder Si ist und dass die Schicht SC2 (32) aus GaN und die Schicht SC1 (31) aus AlGaN ist mit einer Al-Konzentration zwischen 25 bis 30 % inklusive.

10. Optronische Öffnung (200), die ein Fenster (100) nach einem der vorangehenden Ansprüche aufweist, das in eine mechanische elektrisch leitende Struktur (210) eingebaut ist, wobei die Elektrode (40) des Fensters mit dieser elektrisch leitenden Struktur verbunden ist.

**Claims**

1. An optronic porthole (100) which comprises a substrate (10) with two faces (11, 12) with, on one of the faces of the substrate or on both faces, a stack of several heterostructures (30), each heterostructure being composed of at least two semi-conductive layers (31, 32) SC1, SC2, the SC1 layer (31) being doped, the SC2 layer (32) itself comprising a two-dimensional electron gas layer (33) formed at the interface with the SC1 layer, the substrate and the layers being transparent in the 0.4 $\mu$m - 5 $\mu$m band, **characterised in that** it comprises an electrode (40) in contact with all of the electron gas layers (33) and a bi-periodic metallic grid which is buried in the stack, in contact with the electrode (40).

2. The optronic porthole (100) according to the preceding claim, **characterised in that** the grid has regular meshes.

3. The optronic porthole (100) according to either of the preceding claims, **characterised in that** the grid has a wire (50) with a thickness of less than 5 $\mu$m and a pitch of less than 500 $\mu$m.

4. The optronic porthole (100) according to any of the preceding claims, **characterised in that** the semi-conductive SC2 layer (32) is not doped.

5. The optronic porthole (100) according to any of the preceding claims, **characterised in that** the heterostructures (30) are of different thickness and/or are not made of the same materials and/or do not comprise the same number of layers.

6. The optronic porthole (100) according to any of the preceding claims, **characterised in that** it comprises a stack of 10 to 80 heterostructures (30).

7. The optronic porthole (100) according to any of the preceding claims, **characterised in that** it comprises a buffer layer (20) between the substrate (10) and the stack of heterostructures (30).

8. The optronic porthole (100) according to any of the preceding claims, **characterised in that** it comprises one or two anti-reflection layers (60).

9. The optronic porthole (100) according to any of the preceding claims, **characterised in that** the substrate (10) is made of Sapphire or SiC or Si, and **in that** the SC2 layer (32) is made of GaN and the SC1 layer (31) of AlGaN with an A1 concentration of between 25 and 30%.

10. An optronic window (200) which comprises a porthole (100) according to any of the preceding claims, embedded in an electrically conductive mechanical structure (210), the electrode (40) of the porthole being linked to this electrically conductive structure.

(a)

(b)

[0001]

N

Ga

a

a

c

# FIG.1a

# FIG.1b

Canal 2DEG

$E_c$
$E_F$

n-AlGaN          n-AlGaN          n-AlGaN

i-GaN          i-GaN          i-GaN

$E_V$

Direction normale au substrat

FIG.2a

Canal 2DEG

$E_c$
$E_F$

n-AlGaN          n-AlGaN          n-AlGaN

i-GaN          i-GaN          i-GaN

$E_V$

Direction normale au substrat

FIG.2b

EP 2 641 113 B1

FIG.3a

FIG.3b

FIG.4a

FIG.4b

FIG.4c

FIG.5a

Longueur d'onde (µm)

R, T et A

FIG.5b

FIG.6

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6099970 A